# EUROPEAN PATENT APPLICATION

(11) **EP 4 776 008 A1**
(43) Date of publication of application: **15.07.2026**
(21) Application number: 23951466.4
(22) Date of filing: 06.09.2023
(51) Int. Cl.: G01R 31/382, G01R 31/367, G01R 31/392

(54) **INFORMATION PROCESSING DEVICE, INFORMATION PROCESSING METHOD, PROGRAM, AND INFORMATION PROCESSING SYSTEM**

(71) Applicant: Kabushiki Kaisha Toshiba, Tokyo 105-0023 (JP)
(72) Inventor: MARUCHI, Kohei, Tokyo 105-0023 (JP); YAMAMOTO, Takahiro, Tokyo 105-0023 (JP); HATANO, Hisaaki, Tokyo 105-0023 (JP)
(74) Representative: Hoffmann Eitle
(86) International application number: PCT/JP2023/032459
(87) International publication number: WO 2025/052564

(57) **Abstract**

An information processing device includes a processing unit. The processing unit is configured to select, from a plurality of common data being time-series data indicating changes in charging and discharging of the battery and associated with mutually different feature information indicating features of the charging and discharging, a plurality of common data associated with the feature information identical to or similar to specified first feature information, and generates first time-series data for the first feature information by synthesizing the plurality of selected common data.

## Description

### Field

Embodiments of the present invention relate to an information processing device, an information processing method, a program, and an information processing system. Background

The use of secondary batteries is increasing for the purpose of stabilization of a power system, reduction of exhaust gas, and the like. Degradation state monitoring is required to avoid sudden failure of a battery system. For example, proposed are a method for determining a degradation state from data obtained during special charging/discharging, a method for calculating an index regarding a degradation state by using an approximation formula based on the number of charging/discharging cycles or the like (Arrhenius approximation formula), and a method for determining a degradation state from data obtained during normal operation by using estimation models. The estimated models are trained using, for example, application-specific teacher data.

For example, when a battery system is designed, battery evaluation indices such as the amount of current available to a battery for operating conditions and the charge/discharge efficiency for carbon footprint may be calculated.

### Citation List

### Patent Literature

Patent Literature 1: International Publication No. 2021/044635
Patent Literature 2: Japanese Patent No. 6313502
Patent Literature 3: Japanese Patent No. 6759466
Patent Literature 4: Japanese Patent No. 7214884 Summary

### Technical Problem

An object of the present invention is to provide an information processing device, an information processing method, a computer program, and an information processing system that can more efficiently obtain data used for functions such as battery state monitoring and battery evaluation.

### Solution to Problem

An information processing device according to an embodiment includes a processing unit. The processing unit is configured to select, from a plurality of common data being time-series data indicating changes in charging and discharging of a battery and associated with mutually different feature information indicating features of the charging and discharging, a plurality of common data associated with the feature information identical to or similar to specified first feature information, and to generate first time-series data for the first feature information by synthesizing the plurality of selected common data.

### Brief Description of Drawings

FIG. 1 is a block diagram of an information processing system according to an embodiment.
FIG. 2 is a diagram illustrating a configuration example of a battery.
FIG. 3 is a diagram illustrating a configuration example of a module.
FIG. 4 is a diagram illustrating an example of operating data.
FIG. 5 is a diagram illustrating an example of common data.
FIG. 6 is a flowchart of an estimation process in a first embodiment.
FIG. 7 is a diagram for explaining a synthesis example of common data.
FIG. 8 is a diagram for explaining an example of feature information including no common data.
FIG. 9 is a diagram illustrating how data is interpolated.
FIG. 10 is a diagram illustrating an example of a data interpolation method.
FIG. 11 is a diagram illustrating an example of time-series data to be generated.
FIG. 12 is a diagram illustrating an example of time-series data to be generated.
FIG. 13 is a diagram illustrating an example of an output screen for outputting estimation results.
FIG. 14 is a diagram illustrating an example of an output screen displaying warning information.
FIG. 15 is a block diagram of an information processing device of a second embodiment.
FIG. 16 is a flowchart of an evaluation process in the second embodiment.
FIG. 17 is a diagram for explaining an example of an evaluation process.
FIG. 18 is a hardware configuration diagram of an information processing device of the embodiments. Description of Embodiments

With reference to the accompanying drawings, suitable embodiments of an information processing device according to the invention are described in detail below.

A technique of determining a degradation state by using the above estimation model can estimate the state of health (SoH) from data measured during operation, and thus is expected to be applied to primary screening applications for detecting the occurrence of abnormalities without the need to stop a battery and is necessary for monitoring a battery system.

On the other hand, techniques using the estimation model need to prepare application-specific teacher data when deriving the estimation model. For example, estimation of batteries for use in electric vehicle (EV) buses requires teacher data constructed with charging and discharging patterns that simulate the EV buses. Therefore, new data needs to be acquired for each application, resulting in an increase in the time and processing load.

In the following embodiment, data suited to the features (applications) of operating data to be estimated is generated (synthesized) from data common to a plurality of applications (common data). The data generated can be used as application-specific teacher data. This eliminates the need to prepare the application-specific teacher data in advance. That is, data (teacher data) to be used for monitoring battery states can be more efficiently obtained.

The data generated can also be used to calculate battery evaluation indices. That is, the data used for battery evaluation can be more efficiently obtained. The evaluation indices include, for example, the amount of current available to a battery for operating conditions, the charge/discharge efficiency for carbon footprint, and the like.

### (First Embodiment)

An information processing device of the first embodiment generates teacher data used for learning an estimation model for estimating battery states from common data.

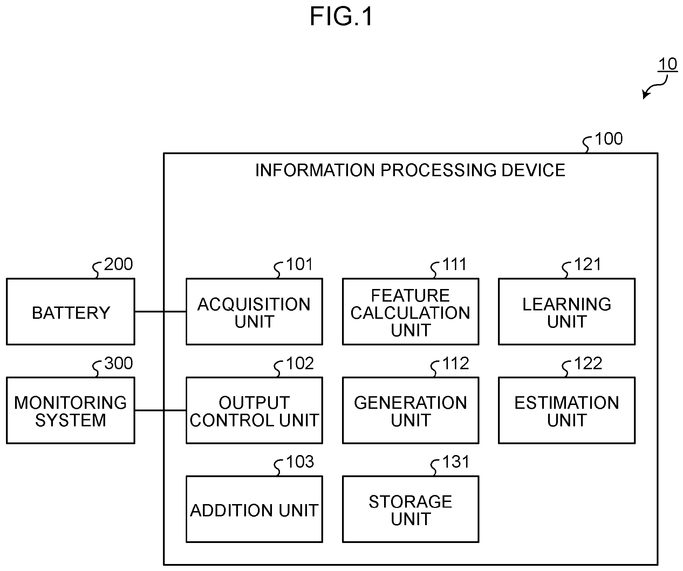

FIG. 1 is a block diagram illustrating an example of the configuration of an information processing system 10 according to the present embodiment. As illustrated in FIG. 1, the information processing system 10 includes an information processing device 100, a battery 200, and a monitoring system 300.

The information processing device 100 and the battery 200, and the information processing device 100 and the monitoring system 300 are connected by networks. The network connecting the information processing device 100 to the battery 200 and the network connecting the information processing device 100 to the monitoring system 300 may be the same network or different networks. The network may be any of a wireless network, a wired network, and a mixed wireless and wired network.

The battery 200 is a battery that can charge and discharge electrical energy. The battery 200 may be configured in any configuration as long as it can acquire operating data for estimating the state of health. The operating data are, for example, voltage, current, temperature, humidity, and the like for each parallel circuit constituting the battery 200.

The battery 200 may be a battery mounted on mobile objects that operate using electrical energy as a power source. The mobile objects include, for example, electric vehicles (EVs), electric buses, electric trains, next-generation light rail transit systems (LRTs), bus rapid transit systems (BRTs), automated guided vehicles (AGVs), airplanes, ships, and the like. The battery 200 may be a battery component mounted on an electrical device (such as a smart phone or a personal computer), a battery that moves power in and out for demand response, and the like. The battery 200 may be a battery for other applications.

The battery 200 is charged by a charger located at a charging station, on the shoulder of a road, in a parking lot, or the like, or a charger connected to an electrical outlet or the like. The power stored in the battery 200 can be discharged (reverse power flow) to a power system via the charger. A method for transmitting power from the charger to the battery 200 may be any of a contact charging method and a non-contact charging method.

A configuration example of the battery 200 is described below. The battery 200 is not limited to such a configuration example. The battery 200 includes a plurality of battery panels. The plurality of battery panels are connected in series or in parallel. Alternatively, the plurality of battery panels are connected in series and in parallel. The battery may also be a single battery.

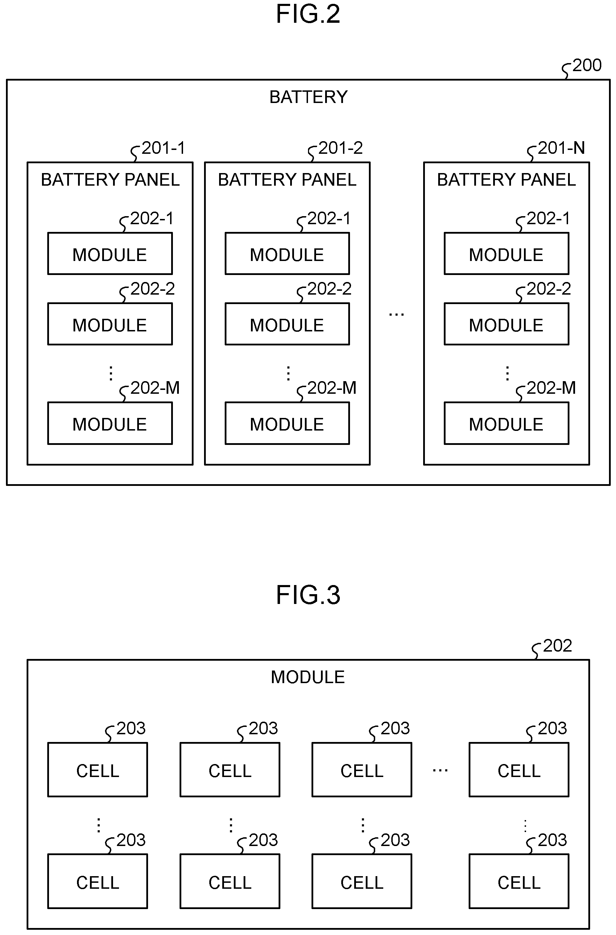

FIG. 2 is a diagram illustrating the configuration example of the battery 200. The battery 200 includes a plurality of battery panels 201-1 to 201-N (N is an integer equal to or greater than 2). Each of the battery panels 201-1 to 201-N includes a plurality of modules 202-1 to 202-M (M is an integer equal to or greater than 2). Since the plurality of battery panels 201-1 to 201-N have similar configurations, the plurality of battery panels 201-1 to 201-N need not to be distinguished from one another and thus are simply referred to as battery panels 201. Since the plurality of modules 202-1 to 202-M have similar configurations, the plurality of modules 202-1 to 202-M need not to be distinguished from one another and thus are simply referred to as modules 202. The configuration illustrated in FIG. 2 is an example, and the battery 200 may be a battery of any other configuration.

The modules 202 are connected in series, in parallel, or in series and in parallel. In the example of FIG. 2, the numbers of modules included in the battery panels 201 are the same, but need not be the same.

FIG. 3 is a diagram illustrating a configuration example of one module 202. The module 202 includes a plurality of battery cells 203. The module 202 may include a temperature sensor and a cell monitoring unit (CMU). The plurality of battery cells 203 are connected in series, in parallel, or in series and in parallel. In the example of FIG. 3, the plurality of battery cells 203 are connected in series and in parallel.

Returning back to FIG. 1, the monitoring system 300 monitors the battery 200 on the basis of information (hereinafter, referred to as "state information") provided by the information processing device 100 and indicating the state of the battery 200. For example, the monitoring system 300 generates screen data to be used for monitoring and displays the generated screen data on a monitor. A user (supervisor) ascertains the state of the battery 200 to be monitored by referring to a screen displayed on the monitor. The monitoring system 300 may control the operation of the battery 200 in response to monitoring results or in response to user commands.

The information processing device 100 includes a storage unit 131, an acquisition unit 101, an output control unit 102, an addition unit 103, a feature calculation unit 111, a generation unit 112, a learning unit 121, and an estimation unit 122.

The storage unit 131 stores therein various information used in the information processing device 100. For example, the storage unit 131 stores therein common data, operating data acquired (input) from the battery 200, the state of health estimated by the estimation unit 122, and information (intermediate product) obtained during estimation.

The storage unit 131 can be formed by any commonly used storage medium such as a flash memory, a memory card, a random access memory (RAM), a hard disk drive (HDD), and an optical disc.

The acquisition unit 101 acquires various information used by the information processing device 100. For example, the acquisition unit 101 acquires operating data of the battery 200 from the battery 200. The operating data is, for example, time-series data including a measurement time (time at which data was measured), a voltage, and a current. The operating data may be acquired at regular time intervals (for example, one second) or irregularly. The acquisition unit 101 stores the acquired operating data in the storage unit 131. The unit for acquiring the operating data may be any of a cell, a module, a battery panel, and the battery 200 (a plurality of battery panels connected to each other). The following description is given on the assumption that the unit for acquiring the operating data is the battery 200.

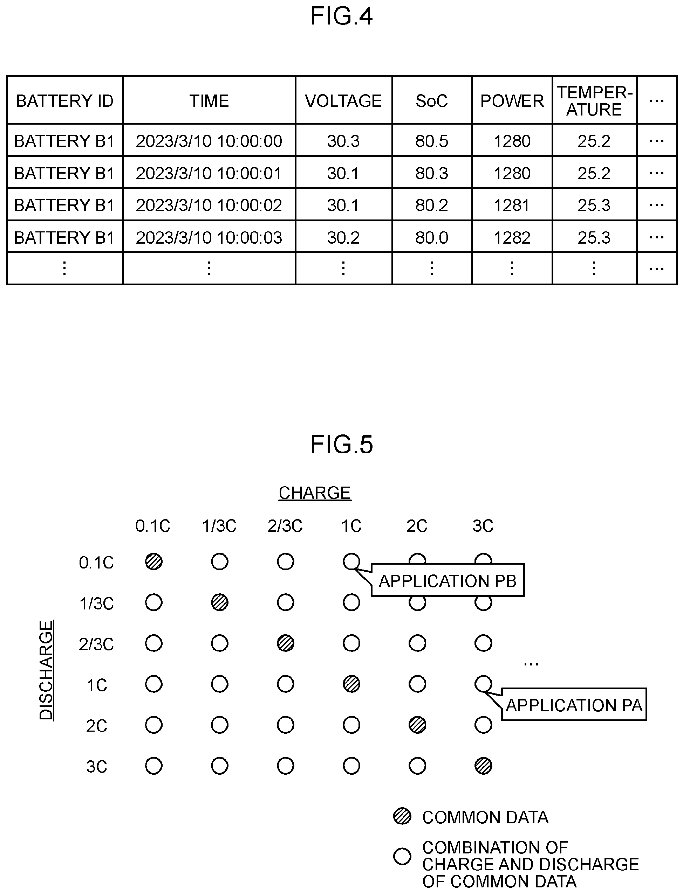

The operating data includes information on, for example, battery identification information (battery ID), time, state of charge (SoC), power, and temperature information. Current may be acquired instead of power. In this case, the value of power may be calculated by an arithmetic operation from the value of current and the value of voltage. The SoC is an index indicating the state of charge in the battery. For example, the SoC is calculated by dividing the amount of electric power (unit Wh) or the amount of electric charge (unit Ah) stored in the battery 200 by the rated capacity (amount of power or amount of charge) of the battery 200. Instead of acquiring the SoC, the SoC may be calculated by integrating a current. FIG. 4 is a diagram illustrating an example of the operating data. As illustrated in FIG. 4, the operating data includes information on battery ID, time, SoC, voltage, power, and temperature.

The operating data may include information indicating the operation state of the battery such as when charging, when discharging, when the system is operating (operational), and when the system is not operating (non-operational). When the state of health is measured, the operating data may be associated with the value of the state of health. Charging or discharging may be distinguished by positive or negative current or power values, or by information (for example, charge/discharge flag) indicating during charging, during discharging, and the like.

The output control unit 102 controls the output of various information used by the information processing device 100. For example, the output control unit 102 outputs the results of the estimation by the estimation unit 122 to the monitoring system 300.

The addition unit 103 adds new common data to the storage unit 131. For example, the addition unit 103 adds data, in which feature information (feature amount) calculated by the feature calculation unit 111 is associated with the operating data acquired by the acquisition unit 101, to the common data stored in the storage unit 131 as new common data. Note that the function of adding the common data is not essential. That is, the information processing device 100 may not include the addition unit 103.

The common data is described below. The common data is time-series data (charge/discharge data) that indicates changes in charging and discharging and is common to a plurality of applications. The common data is, for example, data including operating data obtained when an experiment of charging and discharging the battery 200 is performed so that the values of the feature information are discrete, and the state of health. A plurality of common data are associated with mutually different feature information. For example, the common data is associated with the value of feature information at the time of an experiment. The state of health is estimated, for example, from operating data at the time of an experiment. The estimation may use an estimation model trained in advance to input the operating data and output the state of health. The experiment is desirably performed so that the values of the state of health are also discrete.

Although FIG. 1 illustrates one battery 200, a plurality of batteries 200 may be provided. In this case, common data may be defined for each of the plurality of batteries 200 (for each type of battery).

FIG. 5 is a diagram illustrating an example of common data when a charge rate and a discharge rate are used as feature information. The charge rate and the discharge rate may be collectively referred to as a C rate. The C rate is calculated, for example, by normalizing (dividing) a current value by a rated current or by normalizing (dividing) a power value calculated by multiplying voltage and current by a rated power value.

FIG. 5 illustrates that the common data is operating data obtained when charging and discharging experiments are performed so that the value of the charge rate and the value of the discharge rate are matched. For example, operating data when both the charge rate and the discharge rate are 0.1C, 1/3C, 2/3C, 1C, 2C, and 3C are used as a plurality of common data. In the following, common data in which both the charge rate and the discharge rate are 0.1C may be referred to as common data with a C rate of 0.1C. The same is true for other values of C rate.

Operating data when the value of the charge rate and the value of the discharge rate are different from each other is generated by synthesizing (combining) a plurality of common data. For example, operating data simulating an application PA with a charge rate of 3C and a discharge rate of 1C is generated from data during charging among common data with a C rate of 3C and data during discharging among common data with a C rate of 1C. Similarly, operating data simulating an application PB with a charge rate of 1C and a discharge rate of 0.1C is generated from data during charging among common data with a C rate of 1C and data during discharging among common data with a C rate of 0.1C. The same is true for other combinations of charge and discharge rates.

Returning back to FIG. 1, the feature calculation unit 111 calculates feature information of the operating data from the operating data. For example, the feature calculation unit 111 calculates the feature information (first feature information) of the operating data by using the operating data of the battery 200 (first battery) to be subjected to a state estimation.

The feature information may be any information, and is, for example, data indicating the charging and discharging features of the battery 200. For example, the feature information is some or all of the statistical values of measured values such as power, charge rate, discharge rate, and temperature. The statistical values are, for example, an average value and a value (such as variation) indicating the degree of variation. The feature information may be calculated for the entire operating data, or may be calculated separately for charging and discharging.

In addition to the above, the feature information may further include the following information.
- Cycle of switching between charging and discharging
- Profile information of the battery 200 on, for example, whether calendar deterioration or cycle deterioration has occurred.

The profile information may be given as input or may be estimated from the history of operating data.

The generation unit 112 generates time-series data DA (first time-series data) for feature information FA (first feature information) by synthesizing a plurality of common data with which feature information identical or similar to the feature information FA specified as a target for generating data is associated. For example, the generation unit 112 selects, from a plurality of common data stored in the storage unit 131, the plurality of common data with which the feature information identical or similar to the feature information FA is associated, and generates the time-series data DA by synthesizing the plurality of selected common data. For example, the feature information calculated by the feature calculation unit 111 is specified as the feature information FA.

The learning unit 121 trains an estimation model for estimating the state (for example, state of health) of the battery 200 by using the time-series data DA generated using the feature information FA. The time-series data DA is stored, for example, in association with the state of health. The learning unit 121 trains (constructs and generates) an estimation model for estimating the state of health by using the state of health associated with the time-series data DA as an objective variable and using variables calculated from the time-series data DA as explanatory variables.

The estimation model and the learning method using the estimation model may be any model and method, but for example, the same models and methods as in Patent Literatures 3 and 4 can be used.

The estimation unit 122 estimates the state of the battery 200 by using the trained estimation model.

At least some of the above units (the acquisition unit 101, the output control unit 102, the addition unit 103, the feature calculation unit 111, the generation unit 112, the learning unit 121, and the estimation unit 122) may be implemented by one processing unit. The above units are implemented by one or more processors, for example. For example, each of the above units may be implemented by allowing a processor such as a central processing unit (CPU) and a graphics processing unit (GPU) to execute a computer program, that is, by software. Each of the above units may be implemented by a processor such as a dedicated integrated circuit (IC), that is, hardware. Each of the above units may be implemented using a combination of software and hardware. When a plurality of processors are used, each processor may implement one of the units or two or more of the units.

The information processing device 100 may be formed by one physical device or may be formed by a plurality of physical devices. For example, the information processing device 100 may be constructed on a cloud environment. The units in the information processing device 100 may be distributed among a plurality of devices.

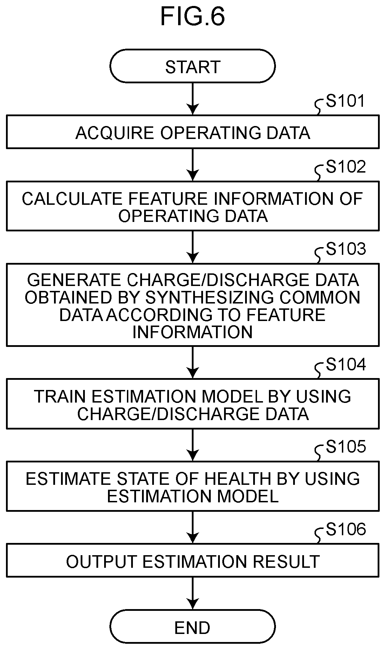

The estimation process performed by the information processing device 100 of the first embodiment is described below. FIG. 6 is a flowchart illustrating an example of the estimation process in the first embodiment. The estimation process includes a process of training an estimation model by using teacher data generated from common data, and a process of estimating the state of the battery 200 by using the trained estimation model.

The acquisition unit 101 acquires the operating data of the battery 200 to be subjected to a state estimation (step S101). The feature calculation unit 111 calculates feature information of the acquired operating data (step S102).

The generation unit 112 generates charge/discharge data obtained by synthesizing common data according to feature information (step S103). This allows the generation of time-series data (charge/discharge data) that is suitable for the feature information of the operating data and indicates changes in charging and discharging. Details of the generation process performed by the generation unit 112 are described below.

The learning unit 121 learns (constructs) an estimation model by using the generated charge/discharge data (step S104). The estimation unit 122 estimates the state of health by using the trained estimation model (step S105). The output control unit 102 outputs the results of the estimation by the estimation unit 122 (step S106), and ends the estimation process.

Details of the generation process are described below. The following describes a case where the feature information is a C rate (charge rate and discharge rate), but the same procedure can be applied to other feature information.

For example, the generation process is specified to generate charge/discharge data for the application PA with a charge rate of 3C and a discharge rate of 1C. In this case, the generation unit 112 generates operating data that simulates the application PA by synthesizing data during charging among common data with a C rate of 3C and data during discharging among common data with a C rate of 1C.

When the common data includes SoC, the generation unit 112 synthesizes a plurality of common data by using the SoC. For example, the generation unit 112 uses, as the data during charging, data among the common data with a C rate of 3C until the SoC increases from a minimum value to a maximum value SoC_Max. The generation unit 112 uses, as the data during discharging, data among the common data with a C rate of 1C until the SoC decreases from the same value as SoC_Max to the minimum value. The generation unit 112 generates operating data that simulates the application PA by combining the data during charging followed by the data during discharging. The time included in the operating data to be generated may be changed in value so that, for example, the data during charging is followed by the data during discharging.

When combining the data during charging followed by the data during discharging as described above, the data during charging is desirably acquired from a fully discharged state, and the data during discharging is desirably acquired from a fully charged state.

When the common data includes no SoC, the generation unit 112 may estimate the SoC from an integrated value of current values or a voltage value and use the estimated SoC. The method for estimating the SoC may be any method used in the related art, such as a method using a Kalman filter.

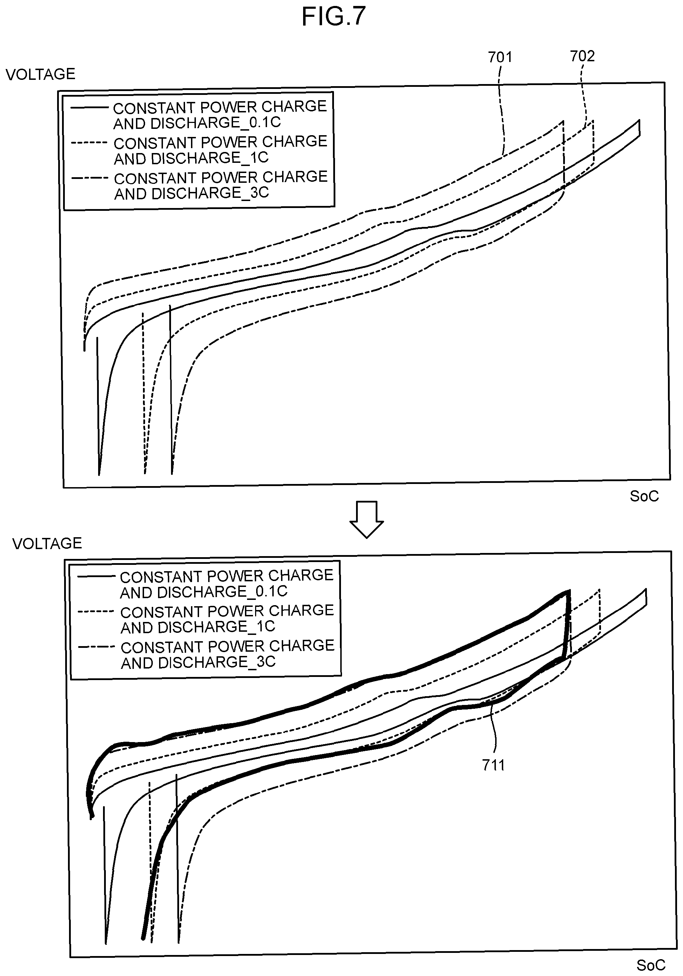

FIG. 7 is a diagram for explaining a synthesis example of common data. The upper part of FIG. 7 is an example of a graph illustrating charging and discharging features for each of three common data. The graph in FIG. 7 illustrating the charging and discharging features is data (QV data) indicating the relationship between SoC and voltage. The three common data have C rates of 0.1C, 1C, and 3C, respectively.

For the application PA, the generation unit 112 selects the common data with a C rate of 3C and the common data with a C rate of 1C from the three common data. In the example of FIG. 7, the common data with a C rate of 3C corresponds to graph 701, and the common data with a C rate of 1C corresponds to graph 702.

The generation unit 112 generates the operating data for the application PA by combining data during charging among the common data with a C rate of 3C and data during discharging among the common data with a C rate of 1C. Graph 711 at the lower part of FIG. 7 corresponds to a graph corresponding to the generated operating data.

In the case of the absence of common data of feature information that matches the value of the feature information FA for a specified application, the generation unit 112 generates the time-series data DA by interpolation including at least one of interpolation and extrapolation using a plurality of common data. The common data used for interpolation corresponds to common data with which feature information similar to the feature information FA is associated.

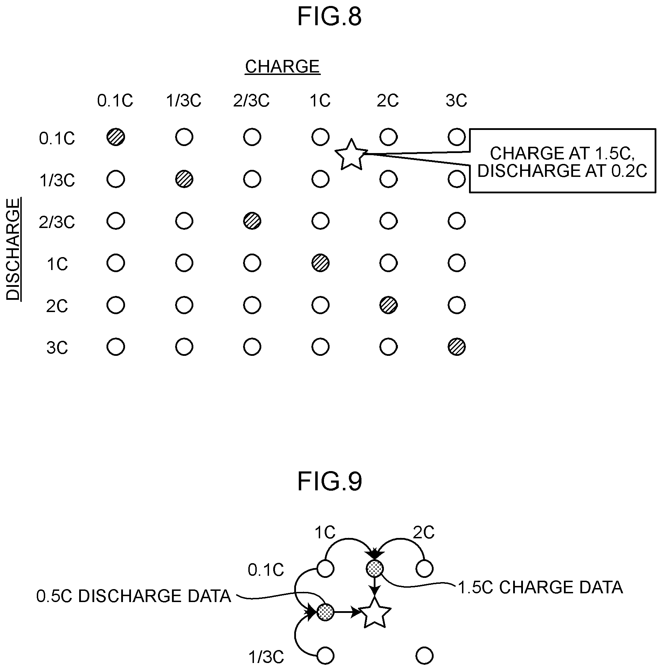

For example, suppose that an application PC with a charge rate of 1.5C and a discharge rate of 0.2C is specified, as illustrated in FIG. 8. In this case, the generation unit 112 generates data during charging with a C rate of 1.5C by interpolation using data during charging among common data with a C rate of 1C and data during discharging among common data with a C rate of 2C. In addition, the generation unit 112 generates data during discharging with a C rate of 0.2C by interpolation using data during charging among common data with a C rate of 0.1C and data during discharging among common data with a C rate of 1/3C. Subsequently, the generation unit 112 generates, as operating data that simulates the application PC, data obtained by combining the generated data during charging and the generated data during discharging. FIG. 9 is a diagram illustrating how the data is interpolated at this time.

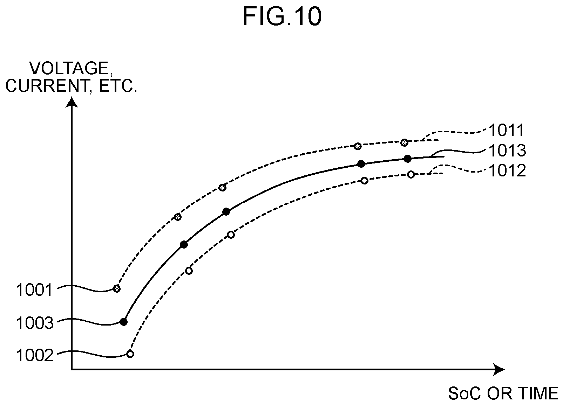

FIG. 10 is a diagram illustrating an example of a specific data interpolation method. As illustrated in FIG. 10, the generation unit 112 prepares a graph with, for example, SoC (or otherwise time) on a horizontal axis and a desired item such as voltage or current on a vertical axis.

Graph 1011 corresponds to data during charging with a C rate of 2C. Graph 1012 corresponds to data during charging with a C rate of 1C. The broken and solid lines are provided for convenience of explanation, and curves corresponding to the broken and solid lines do not need to be obtained.

The generation unit 112 calculates an internal division point 1003 between a point 1001 included in the graph 1011 and a corresponding point 1002 included in the graph 1012. For example, when data with a C rate of 1.5C is interpolated from data with C rates of 2C and 1C, the generation unit 112 calculates, as the internal division point 1003, a point that internally divides the point 1001 and the point 1002 at (2-1.5):(1.5-1). The generation unit 112 performs such a process for each point included in the graph 1011 and the graph 1012. As a result, interpolation results as illustrated in graph 1013 of FIG. 10 are obtained.

When the C rate for the specified application is out of the range of the C rate of the common data (0.1C to 3C in the example of FIG. 5), the generation unit 112 generates the time-series data DA by extrapolation from two common data corresponding to C rates close to the C rate for the specified application. For example, the generation unit 112 calculates an external division point between a point included in one common data and a corresponding point included in the other common data.

Since the calculation using the extrapolation (external division point) may result in large errors, the fact that the calculation uses the extrapolation is desirably clarified through a warning output. Therefore, the generation unit 112, for example, stores extrapolation information indicating that the extrapolation has been made, in association with the generated data. When the extrapolation information is associated, the output control unit 102 may output output information (such as a warning) indicating that the data has been generated by the extrapolation when the data is output. The extrapolation information may include a value (such as a flag) indicating whether the extrapolation has been made, as well as information indicating which item (such as a charge rate, a discharge rate, and temperature) has been extrapolated.

As described above, the generation unit 112 generates the time-series data DA by combining a portion of time-series data indicating changes in charging in common data to which charge rate included in the specified feature information FA is identical or similar and a portion of time-series data indicating changes in discharging in common data to which the discharge rate included in the feature information FA is identical or similar.

When finer (more samples) data than the common data is required, the generation unit 112 may use interpolation techniques such as spline interpolation.

The time-series data DA generated by interpolation or extrapolation can be used as teacher data when the estimation model is trained by the learning unit 121. The trained model learned using the time-series data DA generated by extrapolation may be stored in association with extrapolation information. This allows, for example, the output control unit 102 to output information (such as warning information) indicating whether time-series data generated by extrapolation has been used when the results of estimation by the estimation model are output.

The interpolation process such as interpolation or extrapolation may not be performed, but common data corresponding to feature information close (similar) to feature information of a specified application may be configured to be used as teacher data. In addition, the feature information has so far been the C rate, and may further include temperature.

The following is an example in which an application is specified with a charge rate of 1.5C, a discharge rate of 0.8C, and a temperature of 22°C. In addition to the same charge and discharge rates as above, common data is assumed to be acquired when the temperature is 20°C and 25°C.

In this case, the generation unit 112 selects two common data corresponding to feature information that sandwich the value of the feature information of the specified application within a narrower range, and generates data by combining the selected two common data. When a plurality of feature information is used, the generation unit 112 generates combined data by the number of combinations of the plurality of feature information. For example, when 3 pieces of feature information (a charge rate, a discharge rate, and temperature) are used, 8 pieces of data corresponding to 8 combinations (= 2 × 2 × 2) are generated. The learning unit 121 uses the data by the number of combinations generated in this way as teacher data when training the estimation model.

In the above example, since the charge rate for the specified application is 1.5C, the generation unit 112 selects common data with C rates of 1C and 2C. Since the discharge rate for the specified application is 0.8C, the generation unit 112 selects common data with C rates of 0.5C and 1C. Moreover, since the temperature for the specified application is 22°C, the generation unit 112 selects common data with temperatures of 20°C and 25°C. The generation unit 112 selects one of the two values from each piece of the feature information, combines the selected value with the other feature information, and generates data by synthesizing data during charging and data during discharging for each combination.

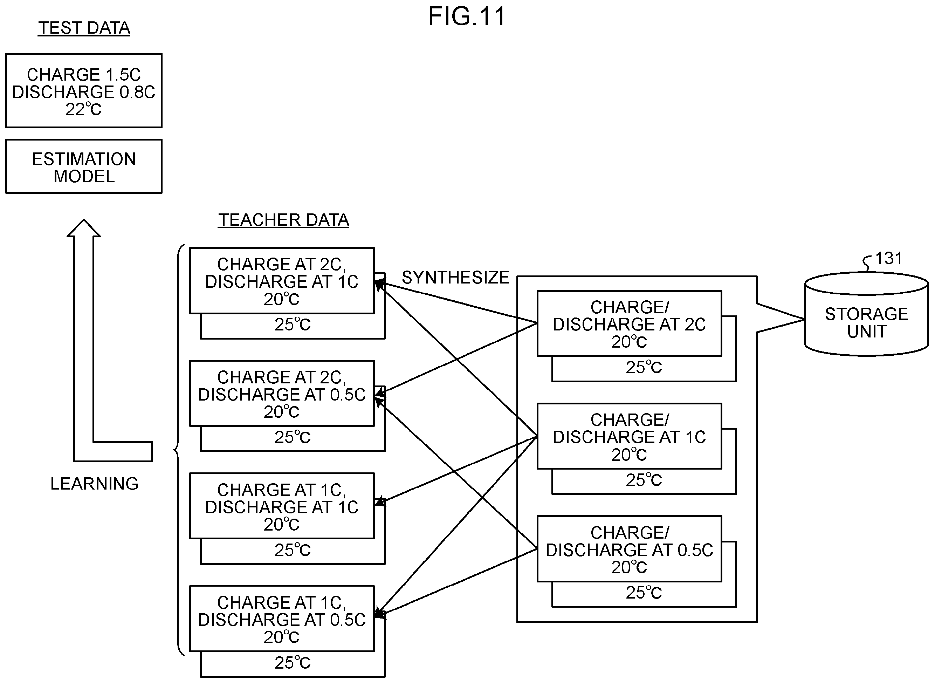

FIG. 11 is a diagram illustrating an example of the time-series data generated in this way. In the example of FIG. 11, the following eight pattern combinations are used.
- Charge rate 2C, discharge rate 1C, temperature 20°C
- Charge rate 2C, discharge rate 1C, temperature 25°C
- Charge rate: 2C, discharge rate: 0.5C, temperature: 20°C
- Charge rate: 2C, discharge rate: 0.5C, temperature: 25°C
- Charge rate 1C, discharge rate 1C, temperature 20°C
- Charge rate 1C, discharge rate 1C, temperature 25°C
- Charge rate 1C, discharge rate 0.5C, temperature 20°C
- Charge rate 1C, discharge rate 0.5C, temperature 25°C

For each of the above eight combinations, the generation unit 112 generates data by synthesizing the two common data. The generated data is used to trrain the estimation model by the learning unit 121. Note that test data is data used for estimation by the estimation model. For example, the test data in FIG. 11 is data obtained under the conditions (applications) that the charge rate is 1.5C, the discharge rate is 0.8C, and the temperature is 22°C.

The test data may be data obtained at different temperatures for charging and discharging. For example, the test data is data obtained under the conditions (applications) that the charge rate is 1.5C, the discharge rate is 0.8C, the temperature during charging is 26°C, and the temperature during discharging is 22°C. In such a case, the generation unit 112 treats the temperature during charging and the temperature during discharging as different feature information, and generates data in the same way as above.

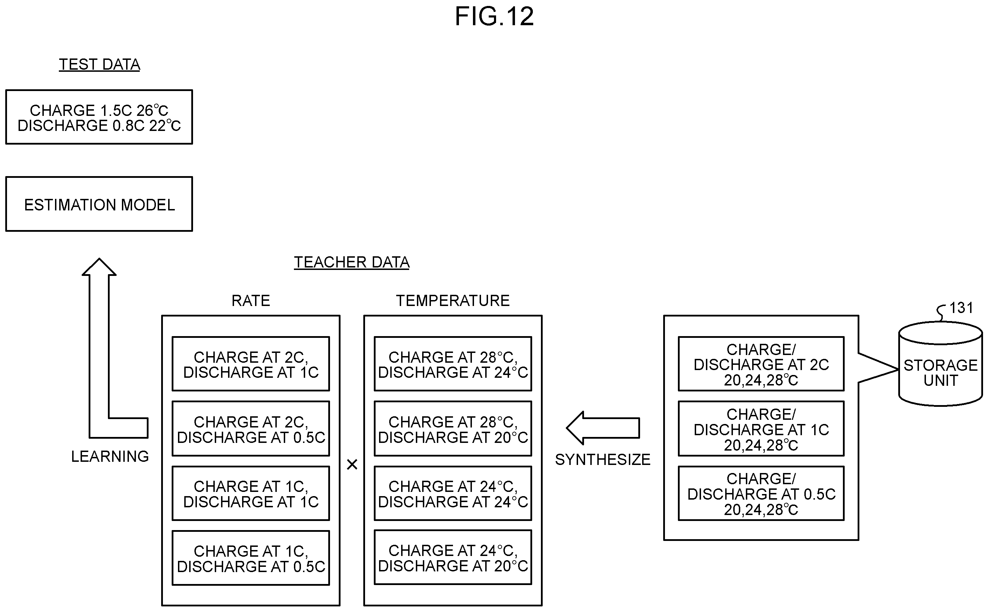

FIG. 12 is a diagram illustrating an example of the time-series data generated in this case. The example of FIG. 12 uses a total of 16 pattern combinations obtained by combining four combinations of charge rates (2C and 1C) and discharge rates (1C and 0.5C) with four combinations of temperatures (28°C and 24°C) during charging and temperatures (24°C and 20°C) during discharging.

In the case of a configuration of performing no interpolation (interpolation and extrapolation) and when the C rate for the specified application is out of the range of the C rate of common data, the generation unit 112 uses a combination of two common data corresponding to a C rate close to the C rate for the specified application. Also in this case, the generation unit 112 stores, for example, extrapolation information indicating that the C rate is out of the range (the same condition as that of the extrapolation), in association with the generated data.

As described above, the generated time-series data DA can be used, for example, as teacher data when the estimation model is learned. The trained estimation model can be used to estimate an index indicating the state of the battery 200, such as a state of health.

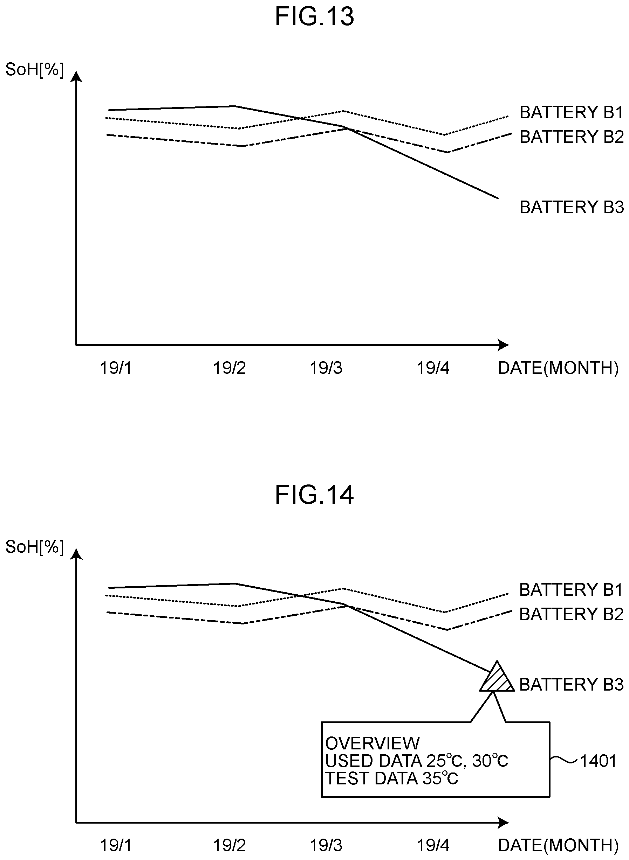

An example of the process of outputting the estimation results of the estimation model by the output control unit 102 is described below. FIG. 13 is a diagram illustrating an example of an output screen for outputting the estimation results. FIG. 13 is an example of an output screen displaying estimation results of a state of health for a plurality of batteries (batteries B1, B2, and B3).

FIG. 14 is a diagram illustrating an example of an output screen further displaying warning information indicating the use of the time-series data DA calculated by extrapolation. As illustrated in FIG. 14, the output screen includes warning information 1401. The warning information 1401 is, for example, in a display format that is displayed when a cursor approaches (such as a pop-up screen), but may be in any other display format. For example, the warning information may be displayed on a separate screen from the output screen. A button (such as an ON or OFF button) may be prepared to specify whether to display the warning information, and the display and non-display of the warning information may be switched in response to the pressing of the button.

Whether the data has been calculated by the extrapolation can be determined, for example, by referring to the extrapolation information stored in association with the estimation model. For example, the output control unit 102 outputs the warning information for estimation results by the estimation model with which the extrapolation information is associated.

In this way, in the first embodiment, data suited to the features (applications) of operating data to be estimated can be generated from common data common to a plurality of applications, and the generated data can be used to train an estimation model. Thus, data (teacher data) to be used for monitoring battery states can be more efficiently obtained.

### (Second Embodiment)

An information processing device of the second embodiment uses data generated from common data to calculate a battery evaluation index. The evaluation index can be used, for example, to evaluate what type of battery is desirable to use when designing a battery system. The following describes an example in which the information processing system 10 includes a plurality of types of batteries 200 and the evaluation index is calculated for each of the plurality of types of batteries 200. In the following, the type of the batteries 200 may be referred to as a cell type.

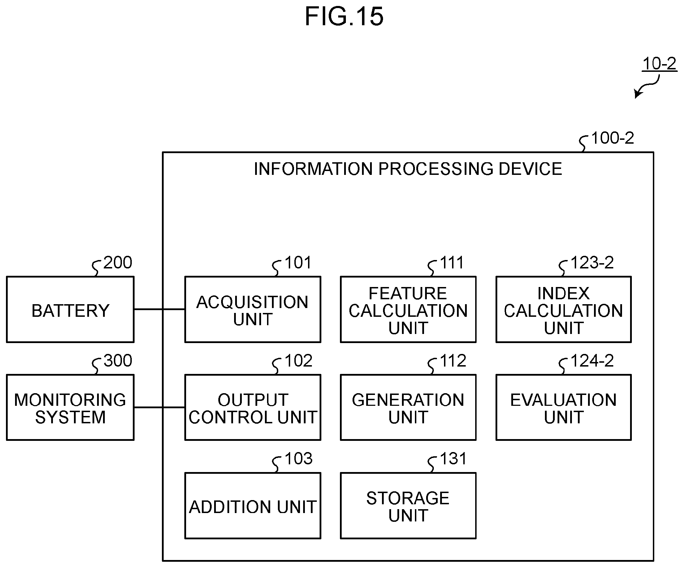

FIG. 15 is a block diagram illustrating an example of the configuration of an information processing system 10-2 including an information processing device 100-2 of the second embodiment. Since the configurations of the battery 200 and the monitoring system 300 are the same as in the first embodiment, the same symbols are used and descriptions thereof are omitted.

As illustrated in FIG. 15, the information processing device 100-2 includes an acquisition unit 101, an output control unit 102, an addition unit 103, a feature calculation unit 111, a generation unit 112, an index calculation unit 123-2, and an evaluation unit 124-2.

The second embodiment is different from the first embodiment in that the index calculation unit 123-2 and the evaluation unit 124-2 are provided instead of the learning unit 121 and the estimation unit 122. Since the other configurations and functions are the same as in FIG. 1 that is a block diagram of the information processing device 100 of the first embodiment, the same symbols are used and descriptions thereof are omitted.

When a plurality of cell types of the batteries 200 are provided, the generation unit 112 generates time-series data DA for each of the plurality of cell types.

The index calculation unit 123-2 calculates the index of a battery of a cell type corresponding to the feature information FA by using the time-series data DA generated by the generation unit 112. The index to be calculated may be any index, and is, for example, the state [Ah] of chargeable and dischargeable charge according to conditions and charge/discharge efficiency for carbon footprint.

Of the state of the chargeable and dischargeable charge, the chargeable capacity is calculated, for example, from the difference between maximum SoC (SoC at which an upper voltage limit is reached) and minimum SoC during charging. The discharge capacity is calculated from the difference between maximum SoC and minimum SoC (SoC at which a lower voltage limit is reached) during discharging. For specific conditions, for example, in order to determine the capacity when a cell with SoC of 80% is charged and discharged at 1C and 22°C, the index calculation unit 123-2 can estimate the chargeable capacity and the discharge capacity by making a synthetic curve for this condition. The index calculation unit 123-2 can also calculate charge/discharge efficiency by using the same method.

When the plurality of cell types of batteries 200 are provided, the index calculation unit 123-2 calculates an index for each of the plurality of cell types by using a plurality of time-series data DA generated for each of the plurality of cell types.

The evaluation unit 124-2 evaluates the plurality of cell types of batteries by using the calculated plurality of indices.

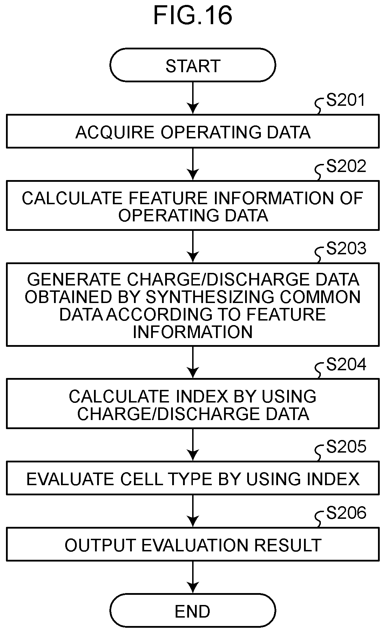

The evaluation process performed by the information processing device 100-2 of the second embodiment is described below with reference to FIG. 16. FIG. 16 is a flowchart illustrating an example of the evaluation process in the second embodiment. The evaluation process includes a process of calculating an index by using data generated from common data and a process of evaluating the battery of each cell type by using the calculated index.

Since steps S201 to S203 are the same as steps S101 to S103 in the information processing device 100 of the first embodiment, descriptions thereof are omitted.

The index calculation unit 123-2 calculates an index by using the generated time-series data (charge/discharge data) (step S204). The evaluation unit 124-2 evaluates a cell type by using the calculated index (step S205). The output control unit 102 outputs the results of the evaluation by the evaluation unit 124-2 (step S206), and ends the evaluation process.

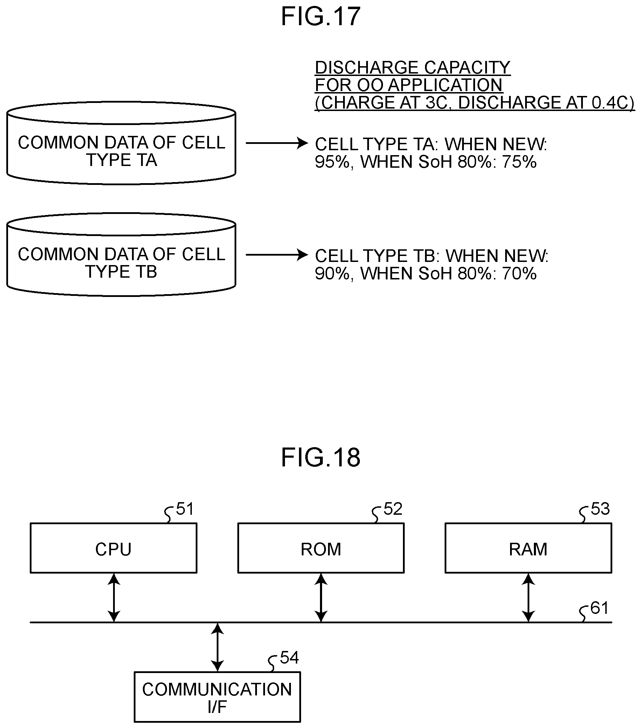

FIG. 17 is a diagram for explaining an example of the evaluation process. The example of FIG. 17 is an example of evaluating cell types suitable for a specific application used at a charge rate of 3C and a discharge rate of 0.4C.

First, common data is prepared for each of a plurality of cell types. FIG. 17 illustrates common data for each of two cell types TA and TB. In the present embodiment, the discharge capacity is calculated for each of the two cell types TA and TB when they are new and when they are in the advanced stages of deterioration (state of health of 80%). By outputting the calculated index (discharge capacity), a designer, for example, can quantitatively ascertain which cell type is suitable for an application to be evaluated.

In this way, the information processing device of the second embodiment can generate data suited to the features (applications) of operating data to be estimated from common data common to a plurality of applications, and use the generated data to calculate battery evaluation indices. Thus, data to be used for a function of evaluating a battery can be more efficiently obtained.

As described above, according to the first and second embodiments, by using common data common to applications without preparing data for each application, data corresponding to a desired application can be generated. Thus, data to be used for functions such as monitoring the state of a battery and evaluating the battery can be more efficiently obtained.

A hardware configuration of the information processing device of the first or second embodiment is described below with reference to FIG. 18. FIG. 18 is an explanatory diagram illustrating of an example of the hardware configuration of the information processing device of the first or second embodiment.

The information processing device of the first or second embodiment includes a control device such as a CPU 51, a storage device such as a read only memory (ROM) 52 and a RAM 53, a communication I/F 54 that connects to a network for communication, and a bus 61 that connects the parts.

The computer program to be executed by the information processing device of the first or second embodiment is provided by being pre-embedded in the ROM 52 or the like.

The computer program to be executed by the information processing device of the first or second embodiment may be configured to be recorded on a computer-readable recording medium, such as a compact disc read only memory (CD-ROM), a flexible disk (FD), a compact disc recordable (CD-R), and a digital versatile disc (DVD), in an installable or executable file format, and to be provided as a computer program product.

Moreover, the computer program to be executed by the information processing device of the first or second embodiment may be configured to be provided by being stored on a computer connected to a network such as the Internet and downloaded via the network. The computer program executed by the information processing device of the first or second embodiment may also be configured to be provided or distributed via the network such as the Internet.

The computer program to be executed by the information processing device of the first or second embodiment can cause the computer to serve as each part of the information processing device described above. In the computer, the CPU 51 can read the computer program from the computer-readable recording medium onto a main storage device and execute the read computer program.

Configuration Examples of the embodiment are described below.

### (Configuration Example 1)

An information processing device comprising
a processing unit configured to select, from a plurality of common data being time-series data indicating changes in charging and discharging of a battery and associated with mutually different feature information indicating features of the charging and discharging, a plurality of common data associated with the feature information identical to or similar to specified first feature information, and to generate first time-series data for the first feature information by synthesizing the plurality of selected common data.

### (Configuration Example 2)

The information processing device according to Configuration Example 1, wherein the processing unit is configured to generate the first time-series data by at least one of interpolation and extrapolation using the plurality of selected common data.

### (Configuration Example 3)

The information processing device according to Configuration Example 2, wherein when the first time-series data is generated by the extrapolation, the processing unit is configured to output output information indicating that the first time-series data is generated by the extrapolation.

### (Configuration Example 4)

The information processing device according to any one of Configuration Examples 1 to 3, wherein the processing unit is configured to:
calculate the first feature information by using operating data of a first battery;
train an estimation model for estimating a state of the first battery by using the first time-series data generated using the calculated first feature information; and
estimate the state of the first battery by using the trained estimation model.

### (Configuration Example 5)

The information processing device according to any one of Configuration Examples 1 to 4, wherein the feature information includes a charge rate, a discharge rate, and temperature.

### (Configuration Example 6)

The information processing device according to Configuration Example 5, wherein the processing unit is configured to generate the first time-series data by combining a portion of the time-series data indicating changes in the charging in the common data to which the charge rate included in the first feature information is similar or identical and a portion of the time-series data indicating changes in the discharging in the common data to which the discharge rate included in the first feature information is identical or similar.

### (Configuration Example 7)

The information processing device according to any one of Configuration Examples 1 to 6, wherein the feature information includes a degree of variation of a charge rate and a degree of variation of a discharge rate.

### (Configuration Example 8)

The information processing device according to any one of Configuration Examples 1 to 7, wherein the feature information includes an average value of temperatures during charging and an average value of temperatures during discharging.

### (Configuration Example 9)

The information processing device according to any one of Configuration Examples 1 to 8, wherein the feature information includes profile information of the battery.

### (Configuration Example 10)

The information processing device according to any one of Configuration Examples 1 to 9, wherein the processing unit is configured to add, to the common data, data that associates feature information of the battery with operating data of the battery.

### (Configuration Example 11)

The information processing device according to any one of Configuration Examples 1 to 10, wherein the processing unit is configured to calculate an index of a battery with a type corresponding to the first feature information by using the generated first time-series data.

### (Configuration Example 12)

The information processing device according to Configuration Example 11, wherein
the common data is defined for each of a plurality of types of batteries, and
the processing unit processors are configured to:
   generate the first time-series data for each of the plurality of types;
   calculate the index for each of the plurality of types by using a plurality of pieces of the first time-series data generated for each of the plurality of types; and
   evaluate the plurality of types of batteries by using the calculated plurality of indices.

### (Configuration Example 13)

An information processing method performed by an information processing device, comprising
a step of selecting, from a plurality of common data being time-series data indicating changes in charging and discharging of a battery and associated with mutually different feature information indicating features of the charging and discharging, a plurality of common data associated with the feature information identical to or similar to specified first feature information, and generating first time-series data for the first feature information by synthesizing the plurality of selected common data.

### (Configuration Example 14)

A program causing a computer to perform
a step of selecting, from a plurality of common data being time-series data indicating changes in charging and discharging of a battery and associated with mutually different feature information indicating features of the charging and discharging, a plurality of common data associated with the feature information identical to or similar to specified first feature information, and generating first time-series data for the first feature information by synthesizing the plurality of selected common data.

### (Configuration Example 15)

An information processing system comprising:
a battery; and
a processing unit configured to select, from a plurality of common data being time-series data indicating changes in charging and discharging of the battery and associated with mutually different feature information indicating features of the charging and discharging, a plurality of common data associated with the feature information identical to or similar to specified first feature information, and to generate first time-series data for the first feature information by synthesizing the plurality of selected common data.

Although several embodiments of the present invention have been described, these embodiments are presented as examples and are not intended to limit the scope of the invention. These novel embodiments can be implemented in various other forms, and various omissions, substitutions, and changes can be made without departing from the gist of the invention. These embodiments and variations thereof are included in the scope and gist of the invention as well as in the inventions described in the claims and their equivalents.

### Reference Signs List

- 1: Information processing system
- 100: Information processing device
- 101: Acquisition unit
- 102: Output control unit
- 103: Addition unit
- 111: Feature calculation unit
- 112: Generation unit
- 121: Learning unit
- 122: Estimation unit
- 123-2: Index calculation unit
- 124-2: Evaluation unit
- 131: Storage unit
- 200: Battery
- 201: Battery panel
- 202: Module
- 203: Battery cell
- 300: Monitoring system

## Claims

1. An information processing device comprising
a processing unit configured to select, from a plurality of common data being time-series data indicating changes in charging and discharging of a battery and associated with mutually different feature information indicating features of the charging and discharging, a plurality of common data associated with the feature information identical to or similar to specified first feature information, and to generate first time-series data for the first feature information by synthesizing the plurality of selected common data.

2. The information processing device according to claim 1, wherein the processing unit is configured to generate the first time-series data by at least one of interpolation and extrapolation using the plurality of selected common data.

3. The information processing device according to claim 2, wherein when the first time-series data is generated by the extrapolation, the processing unit is configured to output output information indicating that the first time-series data is generated by the extrapolation.

4. The information processing device according to claim 1, wherein the processing unit is configured to:
calculate the first feature information by using operating data of a first battery;
train an estimation model for estimating a state of the first battery by using the first time-series data generated using the calculated first feature information; and
estimate the state of the first battery by using the trained estimation model.

5. The information processing device according to claim 1, wherein the feature information includes a charge rate, a discharge rate, and temperature.

6. The information processing device according to claim 5, wherein the processing unit is configured to generate the first time-series data by combining a portion of the time-series data indicating changes in the charging in the common data to which the charge rate included in the first feature information is similar or identical and a portion of the time-series data indicating changes in the discharging in the common data to which the discharge rate included in the first feature information is identical or similar.

7. The information processing device according to claim 1, wherein the feature information includes a degree of variation of a charge rate and a degree of variation of a discharge rate.

8. The information processing device according to claim 1, wherein the feature information includes an average value of temperatures during charging and an average value of temperatures during discharging.

9. The information processing device according to claim 1, wherein the feature information includes profile information of the battery.

10. The information processing device according to claim 1, wherein the processing unit is configured to add, to the common data, data that associates feature information of the battery with operating data of the battery.

11. The information processing device according to claim 1, wherein the processing unit is configured to calculate an index of a battery with a type corresponding to the first feature information by using the generated first time-series data.

12. The information processing device according to claim 11, wherein
the common data is defined for each of a plurality of types of batteries, and
the processing unit is configured to:
generate the first time-series data for each of the plurality of types;
calculate the index for each of the plurality of types by using a plurality of pieces of the first time-series data generated for each of the plurality of types; and
evaluate the plurality of types of batteries by using the calculated plurality of indices.

13. An information processing method performed by an information processing device, comprising
a step of selecting, from a plurality of common data being time-series data indicating changes in charging and discharging of a battery and associated with mutually different feature information indicating features of the charging and discharging, a plurality of common data associated with the feature information identical to or similar to specified first feature information, and generating first time-series data for the first feature information by synthesizing the plurality of selected common data.

14. A program causing a computer to perform
a step of selecting, from a plurality of common data being time-series data indicating changes in charging and discharging of a battery and associated with mutually different feature information indicating features of the charging and discharging, a plurality of common data associated with the feature information identical to or similar to specified first feature information, and generating first time-series data for the first feature information by synthesizing the plurality of selected common data.

15. An information processing system comprising:
a battery; and
a processing unit configured to select, from a plurality of common data being time-series data indicating changes in charging and discharging of the battery and associated with mutually different feature information indicating features of the charging and discharging, a plurality of common data associated with the feature information identical to or similar to specified first feature information, and to generate first time-series data for the first feature information by synthesizing the plurality of selected common data.
